# EUROPEAN PATENT SPECIFICATION

(11) **EP 4 730 333 B1**
(45) Date of publication and mention of the grant of the patent: **23.09.2026**
(21) Application number: 24207810.3
(22) Date of filing: 21.10.2024
(51) Int. Cl.: H10W 20/00, H10W 20/20, H10W 20/41, H10W 70/05

(54) **A METHOD FOR PRODUCING A THROUGH-SEMICONDUCTOR CONNECTION**
VERFAHREN ZUR HERSTELLUNG EINER HALBLEITERDURCHVERBINDUNG
PROCÉDÉ DE FABRICATION D'UNE CONNEXION À SEMI-CONDUCTEUR

(43) Date of publication of application: 22.04.2026
(73) Proprietor: Imec VZW, 3001 Leuven (BE)
(72) Inventor: Witters, Liesbeth, 3210 Lubbeek (BE); Shigetoshi, Takushi, 3000 Leuven (BE); Beyne, Eric, 3001 Heverlee (BE)
(74) Representative: Patent Department IMEC

(56) References cited:
- US-A1- 2016 079 161
- US-A1- 2023 178 589
- US-A1- 2023 253 322

## Description

### Field of the Invention

The present invention is related to semiconductor processing, as applied for the production of semiconductor components such as integrated circuit (IC) chips. The invention relates in particular to connections which enable the conduction of current between the front and back sides of the component.

### State of the art.

Multiple semiconductor components such as ICs are processed simultaneously on a large semiconductor wafer, usually a silicon wafer. Due to congestion of routing on the wafer frontside for advanced technological nodes, part of the functionality can be moved from the wafer frontside to the wafer backside. This allows for a continued density scaling of device structures. An example of this is the power delivery network that is moved to the backside of the wafer.

Making a through wafer connection between the frontside and the backside design involves bonding the wafer to a carrier substrate and thinning the wafer from the back side prior to backside layer patterning. In case the initial wafer substrate is not fully removed during thinning, connections must be made through the thinned wafer material, for connecting devices at the front side to the back side of the eventual IC. Local through-connections are referred to as 'substrate vias' (SV) or 'through substrate vias' (TSVs). These are local via connections from the back side of a substrate (such as the thinned wafer) and contacting a conductive structure at the front side of the substrate. Other through-connections are elongate structures such as power rails or conductive lines. The structures at the front side may also be local via connections, or elongate structures such as buried power rails.

In most cases, the connecting features need to be electrically isolated from the thinned wafer material, typically using a dielectric liner. Highest densities can be achieved using tip to tip connections between frontside features (e.g. a buried power rail or highly doped epitaxial source or drain of the transistors) and the connecting features (e.g. TSV or metal line). For high density designs, the overlay requirements for backside to frontside patterns can be very small and at the limit of what the scanner can correct for. This potentially puts a limitation on the densities that can be achieved.

US 2023/253322 A1 discloses a method for producing an electrical connection through a thinned semiconductor substrate, the substrate comprising multiple semiconductor devices on its front side and front end of line conductive structures, the method includes producing an opening through the back side of the thinned substrate, said opening at least partially overlapping with an end surface of one of said conductive structures.

US 2016/079161 A1 discloses a via which is misaligned with respect to to front-end conduction line and creates an additional cavity at the misaligned part of its bottom. US 2023/178589 A1 discloses a guard ring to improve the structural stability of a via.

### Summary of the invention

The invention is related to a method and to a semiconductor component as disclosed in the appended claims. According to the invention, a thinned semiconductor substrate is provided having a front end of line (FEOL) portion on its front side. The FEOL portion includes conductive structures at the front side of the thinned substrate, such as buried power rails or via connections which need to be contacted by connections through the substrate. For producing such a through-connection, an opening is etched from the back of the thinned substrate, to be filled with a conductive material. The bottom of said opening overlaps at least partially the end surface of the conductive structure to be contacted, and further overlaps one or more portions of semiconductor material of the substrate. This may be due to a degree of misalignment of the opening relative to the end surface, or to the dimensions of the opening relative to said end surface, or to the orientation of the opening relative to semiconductor features on the substrate surface, such as semiconductor fins, or to a combination of these circumstances. According to the invention, etching of the opening continues beyond the end surface into said semiconductor portion(s), to thereby create one or more cavities, at least one being in the vicinity of said end surface.

A first dielectric layer is formed on the sidewalls and bottom of the opening, so that the cavity or cavities are filled with the material of the first layer. This material is then removed by an isotropic etch so that it may be removed everywhere except in the cavity or cavities. If necessary, a second dielectric layer **may be formed** as a liner on the sidewalls and bottom of the opening, to be opened up at the bottom by an anisotropic etch to thereby expose said end surface. The dielectric of the first layer however remains in the cavity or cavities. These dielectric-filled cavities thereby inhibit the formation of shorts between the eventual through-connection obtained by filling the opening, and the semiconductor material of the substrate.

The invention thereby allows a larger degree of misalignment, enabling higher densities in the layer designs on the front and back side of the substrate. For larger through-connections especially, the dielectric-filled cavities may be beneficial in terms of mitigating stress in the vicinity of the connection.

The invention is in particular related to a method for producing an electrical connection through a thinned semiconductor substrate, the substrate comprising a bulk portion having a front side and a back side, wherein multiple semiconductor devices at least partly formed of semiconductor material of the substrate are located on said front side, and wherein:
- said devices are part of a front end of line portion, said front end of line portion further comprising conductive structures which are part of or connected to one or more of said semiconductor devices, one of said conductive structures having an end surface that is to be contacted by the electrical connection,
- the method includes producing the front end of line portion on the front side of an initial substrate and thinning the initial substrate from the back side, to thereby obtain the thinned substrate,
characterized in that the method thereafter comprises the consecutively applied steps of :
- producing an opening through the back side of the thinned substrate, by an etch process that is selective with respect to said end surface of the conductive structure or with respect to a dielectric layer isolating the conductive structure from the material of the substrate, wherein the bottom of said opening overlaps :
   ∘ at least partially the end surface of the conductive structure,
   ∘ one or more portions of semiconductor material of the substrate, **and wherein** the etch process continues beyond said end surface into said one or more semiconductor portions, so that at least one cavity is formed, and so that the bottom of the opening comprises:
      ∘ a first portion at least partially overlapping the end surface of the conductive structure and
      ∘ a second portion defined by the bottom of the cavity or cavities, wherein material of the substrate is exposed in said second portion of the bottom of the opening,
- depositing a first dielectric layer on the bottom and on the sidewalls of the opening, the thickness of said layer being such that the at least one cavity is completely filled with the material of the first dielectric layer,
- partially removing the first dielectric layer by an isotropic etch process configured to thin or completely remove the first dielectric layer on the sidewalls of the opening, and wherein the material of the first dielectric layer is thinned or removed from the first part of the bottom of the opening but maintained in the at least one cavity, to thereby create one or more dielectric-filled cavities,
- either using the thinned first dielectric layer as a dielectric liner covering the sidewalls of the opening and the first part of the bottom of the opening, or if the first dielectric layer is fully removed from said sidewalls and first part of the bottom of the opening, depositing a second dielectric layer to serve as said dielectric liner,
- by an anisotropic etch, exposing the end surface of the conductive structure, whilst maintaining the dielectric liner on the sidewalls of the opening and whilst maintaining the material of the first dielectric layer in the at least one cavity,
- filling the opening with an electrically conductive material, to thereby form the electrical connection through the thinned substrate, so that the connection is isolated from the material of the substrate by the dielectric liner and by the dielectric-filled cavity or cavities.

According to an embodiment, the end surface of the conductive structure is buried in the bulk portion of the substrate at the front side thereof, and the opening is misaligned and/or wider with respect to the width of the conductive structure in a given direction, so that the at least one cavity is formed in the bulk portion of the substrate. According to embodiments, the conductive structure may be a buried power rail or a source or drain of a transistor.

According to an embodiment, the end surface of the conductive structure is in close proximity to a semiconductor portion of a semiconductor device located on the front side of the bulk portion of the substrate, and the at least one cavity is formed in said semiconductor portion of said device.

According to an embodiment, the opening is wider and/or misaligned with respect to the width of the conductive structure, as measured in a given direction.

According to an embodiment, the semiconductor portion of the device is a fin-shaped portion extending in a longitudinal direction, wherein said given direction is perpendicular to the longitudinal direction of the fin-shaped portion.

According to an embodiment, the semiconductor portion of the device is a fin-shaped portion extending in a longitudinal direction, wherein the opening is an elongate opening oriented transversely with respect to said longitudinal direction and wherein the length of the opening fully overlaps the width of the fin-shaped portion. According to embodiments, the conductive structure is a via connection.

According to an embodiment, the electrical connection through the substrate is a through substrate via, a conductive line or a power rail.

According to an embodiment, the first dielectric layer is a uniform layer formed of a single dielectric material.

According to an embodiment, the first dielectric layer is a stack of a first and second dielectric layer, wherein the second layer is removable selectively with respect to the first layer, by said isotropic etch process.

The invention is also related to a semiconductor component comprising a semiconductor substrate comprising a bulk portion having a front side and a back side, wherein the substrate comprises a front end of line portion on the front side of the bulk portion, the front end of line portion comprising electrically conductive structures which are part of or connected to semiconductor devices within said front end of line portion, characterized in that the component comprises at least one electrical connection passing through the substrate from the back side of the substrate and contacting an end surface of one of said conductive structures while being isolated from the material of the substrate by a dielectric liner, and by at least one dielectric-filled cavity in the vicinity of the end surface of the conductive structure.

According to an embodiment of the semiconductor component, the conductive structure is one of the following :
- a buried power rail,
- a source or drain of a transistor,
- a via connection.

According to an embodiment of the semiconductor component, the electrical connection through the substrate is one of the following :
- a through substrate via,
- a conductive line,
- a power rail.

### Brief description of the figures

Figure 1 shows a small section of a typical front end of line layout as processed on the front side of a semiconductor wafer.
Figure 2 shows the face-down bonding of the processed wafer to a carrier wafer, prior to back side thinning of the processed wafer.
Figure 3 shows the bonded semiconductor wafer after back side thinning.
Figures 4a to 4g illustrate the production of a through substrate via (TSV) for contacting a buried power rail according to a prior art method, wherein the TSV is perfectly aligned to the buried rail.
Figure 5 shows the maximum amount of misalignment that is allowable using the prior art method, without creating a short between the TSV and the wafer material.
Figure 6 shows a larger misalignment and the unwanted consequence thereof (using the prior art method), which is the creation of a short between the TSV and the wafer material.
Figures 7a to 7e illustrate a first embodiment of the method of the invention for forming a TSV contacting a buried power rail in a via opening that is misaligned to the rail.
Figures 8a to 8e illustrate a second embodiment.
Figures 9a to 9h illustrate the application of the invention for contacting the source of a nano-sheet transistor by a TSV that is misaligned to said source.
Figures 10a to 10c illustrate an embodiment wherein the thick dielectric is a stack of a first and second dielectric layer.
Figures 11a to 11f illustrate the application of the invention for forming a TSV contacting a buried power rail, wherein the TSV is misaligned to the buried rail and wider than the rail.
Figure 12 shows another front end of line layout processed on the front side a semiconductor wafer, suitable for applying thereto another embodiment of the method of the invention.
Figure 13 shows the wafer of Figure 12 after bonding to a carrier and thinning the bulk portion of the wafer.
Figures 14a to 14f illustrate an embodiment of the invention, applied to the configuration shown in Figure 13.
Figures 15a to 15d illustrate a variant of the embodiment of Figures 14a-14f, wherein the full width of a semiconductor fin is covered by the width of a through-connection.
Figures 16a to 16g illustrate an embodiment wherein an elongate through-connection is formed to contact a via connection, and wherein the through-connection is oriented perpendicularly to the orientation of the fins at the front side.

### Detailed description of the invention

The problem set out in the introduction will first be illustrated on the basis of a specific exemplary configuration, after which the solution provided by the invention will be demonstrated on the same and other configurations. Throughout the present specification, the term 'conductive' is to be understood as 'electrically conductive'.

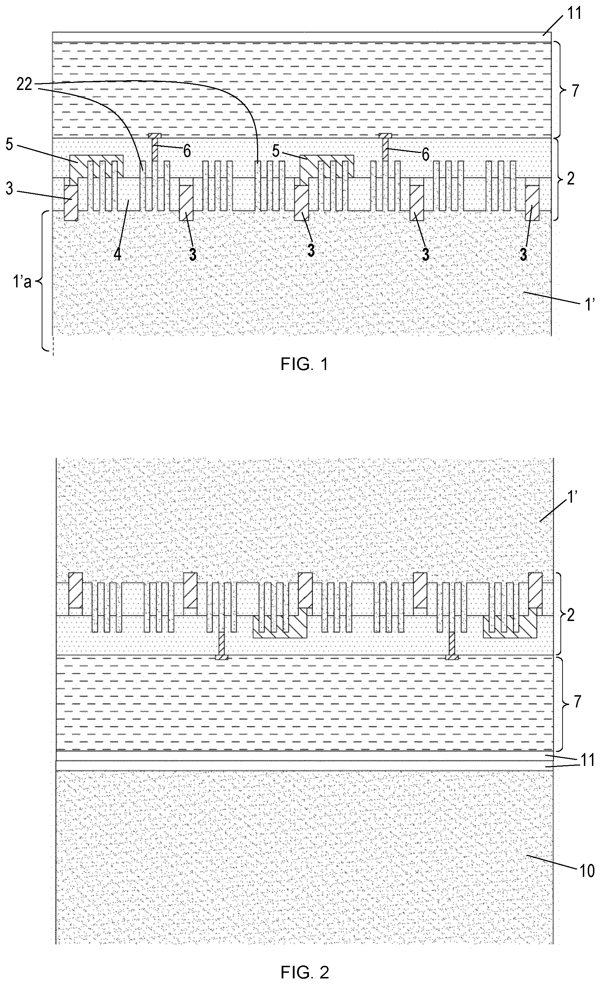

Figure 1 is a schematic and simplified cross-section of a small portion of a semiconductor substrate 1', which may be a standard silicon process wafer, on the front side of which a number of processing steps have been performed, which have led to the creation of multiple devices in a front end of line (FEOL) portion 2 of an electronic component, such as an integrated circuit. In the specific example, these include fin-based transistors whose source areas are connected to buried power rails 3. The transistors are processed on silicon fins 22 integral with the bulk portion 1'a of the substrate 1', and extending upward from said bulk portion. The transistors are therefore at least partially formed of the semiconductor material of the substrate 1'. Structural details of such transistors are known as such and no such details are shown in the simplified drawing. The power rails 3 are longitudinal metal structures partly buried in the bulk portion 1'a, and partly in the dielectric material 4, commonly referred to as STI dielectric (shallow trench isolation), formed between the fins 22. The width of the rails 3 may be in the order of a few tens of nanometres and the rails may extend over relatively long distances in the longitudinal direction of the fins 22. The rails 3 are isolated from the substrate material by a dielectric liner not shown explicitly in Figure 1. Local interconnects 5 couple the transistors to the rails 3 at dedicated locations. Further connections 6 couple the transistors to a multilayer interconnect structure 7 also referred to as the back end of line (BEOL) portion, illustrated in a simplified fashion in the drawing. The aim is to access the buried power rails 3 from the backside in order to connect the rails to a back side power delivery network.

In order to realize this, the substrate is first bonded face down to a carrier substrate 10, as illustrated in Figure 2. The carrier can be a temporary carrier, to be released at a later stage, or it can be another process wafer comprising FEOL and BEOL portions, to which the substrate is permanently bonded to form a stacked device configuration.

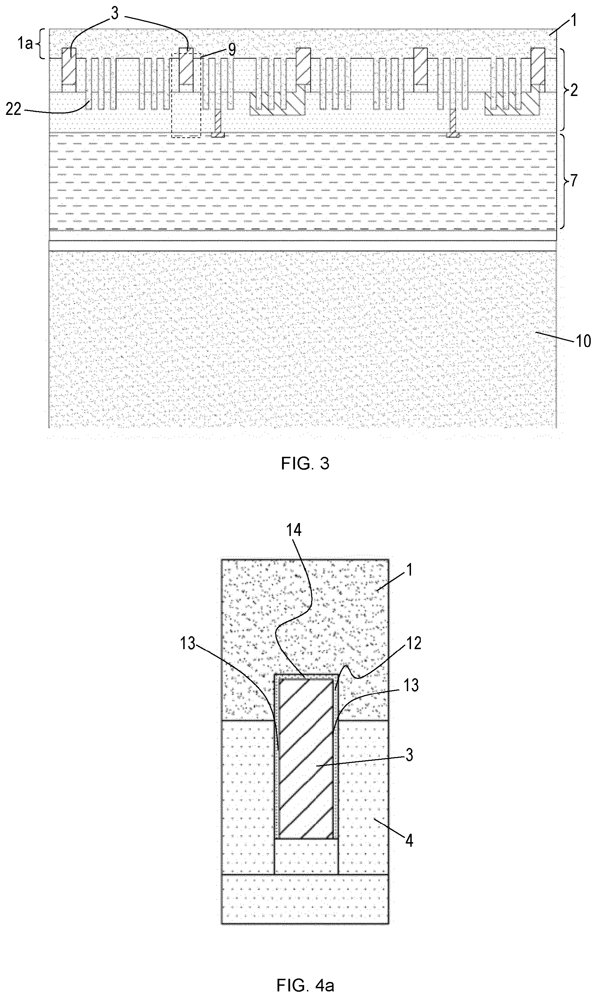

The carrier 10 and the substrate 1' are provided with bonding layers 11 which enable to form a bond between these substrates. Then the bulk portion 1'a is thinned from the back side, which may be done by grinding techniques and CMP (chemical mechanical polishing), possibly ending with a wet etch step, stopped by an etch stop layer incorporated in the substrate, in order to enable thinning to a very low thickness, in the order of 1 micrometer or less. The result of the substrate thinning step is illustrated in Figure 3, showing the thinned substrate 1, comprising bulk portion 1a, with fins 22 extending from the bulk portion at the front side thereof.

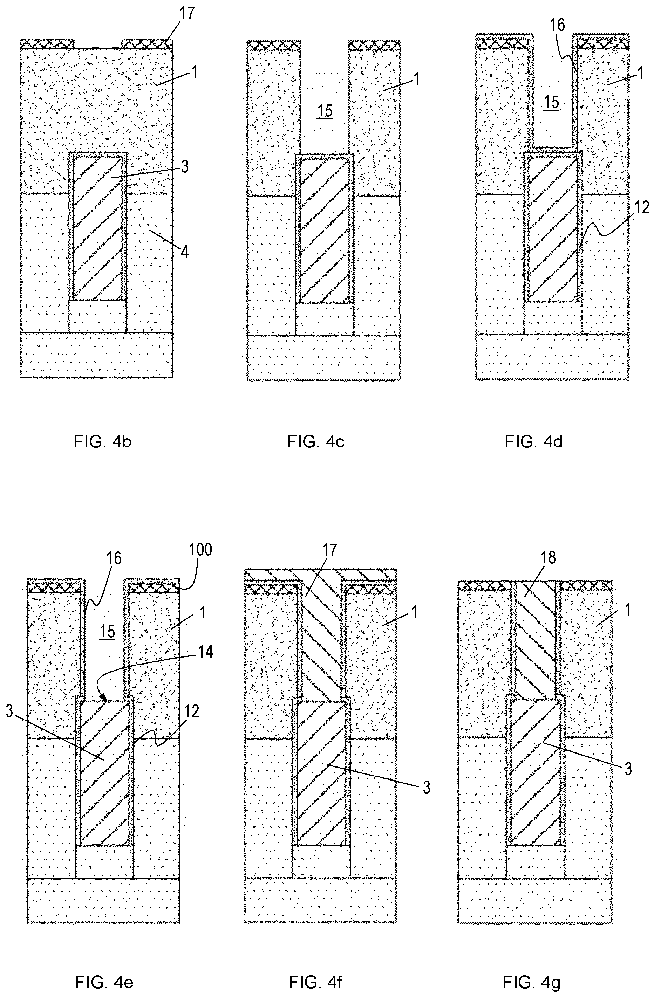

Figure 4a shows an enlarged image of the rectangle 9 in Figure 3 comprising one of the buried power rails 3, this time showing also the dielectric layer 12, hereafter referred to as a liner, that isolates the rail from the substrate material 1. The rail 3 is a conductive structure extending in a longitudinal direction and defined by two sidewalls 13 parallel to said longitudinal direction and by an end surface 14 buried in the bulk portion 1a of the semiconductor substrate 1. The end surface 14 of the rail is to be contacted by a through substrate via (TSV) through the thinned substrate 1. The term TSV is used in this description for all local via connections passing through the thinned substrate from the back side. Another possible term for these connections is the more generic 'substrate via' (SV). Figures 4b to 4g illustrate the required steps in case there is a perfect alignment between the TSV and the buried rail, for a TSV that is narrower than the width of the rail. In the drawings, the TSV is supposed to have a constant cross-section, but it is known that TSVs may be narrower at the bottom than at the top. Within the present context, the 'width of the TSV' is to be understood therefore as the width at the bottom of the TSV, as measured perpendicularly to the structure that is to be contacted (in this case the buried rail 3). In a cross section parallel to the substrate 1, the TSV may have a round shape, a square shape or a rectangular shape, extending parallel to the rail over a short distance relative to the length of the rail. When said distance is longer, the through-connection is no longer referred to as an TSV, but rather as a line-shaped through-connection or conductive line running parallel to the longitudinal direction of the rail or equivalent conductive structure. The method of the invention as described hereafter is however applicable without changes to TSVs as well as to longer conductive lines.

With reference to Figure 4b, a dielectric hardmask layer 17, for example a SiN or a SiO₂ layer, is formed on the surface of the thinned substrate 1, and the hardmask layer is patterned to form an opening therein, with perfect alignment to the buried rail 3. As illustrated in Figure 4c, a via opening 15 is then formed by anisotropically etching the substrate material relative to the patterned hardmask layer 17 stopping on the liner 12 of the buried rail 3.

A dielectric liner 16 is formed on the sidewalls (Fig. 4d) and bottom of the via opening 15, and subsequently the liners 16 and 12 are removed from the bottom of the via opening 15 by an anisotropic etch process (Fig. 4e), thereby exposing the end surface 14 of the rail 3. The liner 16 may be formed for example of silicon oxide, deposited by atomic layer deposition.

The process for removing the liners 16 and 12 from the bottom of the via opening 15 may be a plasma etch according to a known recipe, that preserves the layers on the sidewalls while removing the horizontal layers 16,12 on the bottom of the via opening 15 and on the end surface 14 of the buried rail 3. For example, the plasma etch method as described in patent publication document EP3035369 can be used, wherein a polymer layer is formed on the sidewalls and the upper surface of the liner 16, while said liner 16 and the liner 12 on the end surface 14 of the rails are removed at the bottom of the via opening. Afterwards, the polymer layer is also removed selectively with respect to the remaining liner 16, resulting in the image shown in Figure 4e. After this, the via opening 15 is filled with an electrically conductive material, preferably a metal, as illustrated in Figure 4f. This may for example be tungsten, ruthenium, molybdenum or cobalt, formed by atomic layer deposition (ALD). This is followed by planarization to remove the metal and the liner material from the surface of the thinned semiconductor substrate 1. Alternatively, the liner material may be maintained on the surface of the thinned substrate. The result is shown in Figure 4g : a perfectly aligned through substrate via 18 contacts the buried rail 3. The TSV 18 is ready to be contacted by further conductors within layers to be processed on the planarized back side of the thinned substrate 1. The hardmask 17 remains and will form an isolation layer between the substrate 1 and further conductors processed on the back side thereof.

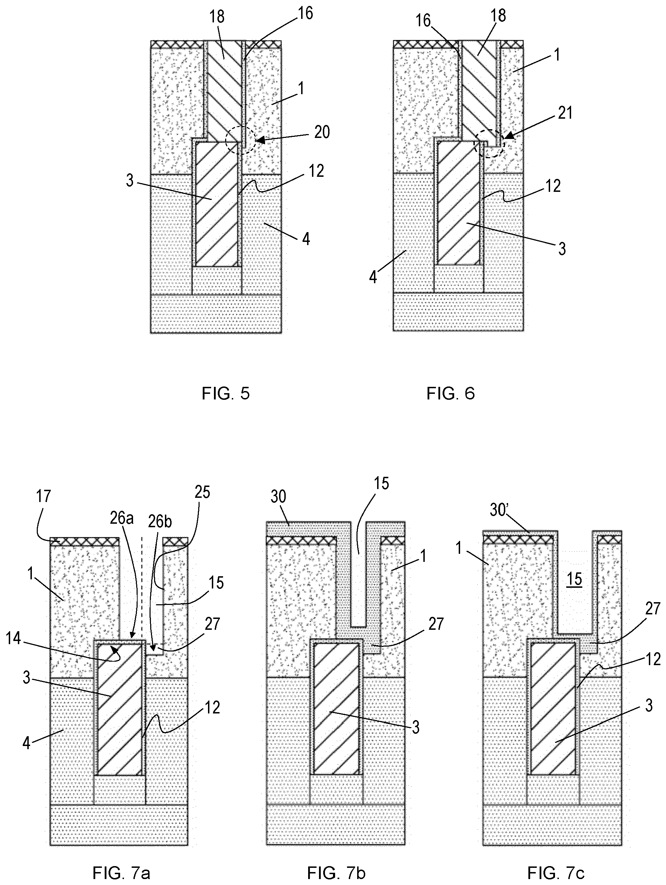

The perfect alignment is however not guaranteed, and misalignment between the via opening 15 and the rail 3 is likely to occur. Figure 5 illustrates the maximum allowable misalignment : the overlapping liners in area 20 are still isolating the connected rail 3 and TSV 18 from the substrate material 1. However, when the misalignment is larger, the situation shown in Figure 6 occurs: part of the exposed bottom of the via opening 15 is in direct contact with the bulk of the substrate 1, and the resulting TSV 18 therefore connects to the substrate in area 21, i.e. a short is formed between the TSV 18 and the substrate 1 at this location.

The present invention provides a solution to the occurrence of shorts as described above. Figure 7a shows a misaligned via opening 15 that is certain to lead to the short in area 21 as described hereabove when prior art methods are used. The misalignment is such that (as seen in the cross-section), one side 25 of the via opening 15 lies outside the width of the buried rail 3. This means that a first part 26a of the bottom of the via opening 15 overlaps the end surface 14 of the rail 3, while a second part 26b lies adjacent said end surface 14. Because of the degree of misalignment and because the etch process for forming the via opening 15 continues down to a given depth beyond the end surface 14 of the buried rail, the second part 26b is deeper than the first part 26a and thereby forms the bottom of a cavity 27 lying adjacent the end surface 14 of the buried rail 3.

A thick dielectric layer 30 is now formed on the bottom and the sidewalls of the via opening 15, as shown in Figure 7b. The thickness of the dielectric layer 30 is sufficient to fill the cavity 27 with dielectric material, without however filling the via opening 15 completely. The dielectric material may for example be silicon oxide, deposited by atomic layer deposition which ensures that the cavity 27 is fully filled. In the illustrated embodiment, the layer 30 is a uniform layer formed of a single dielectric material, however, layer 30 could also be formed of multiple stacked dielectric layers of different materials, as explained later in this description.

Then an isotropic etch process is performed on the dielectric layer 30, i.e. the material is removed at the same rate in all directions. In the embodiment shown, this etch process is stopped when only a thin dielectric layer 30' remains on the sidewalls of the via opening 15, and on the first part 26a of the bottom of the opening, while the cavity 27 remains filled with the material of dielectric layer 30.

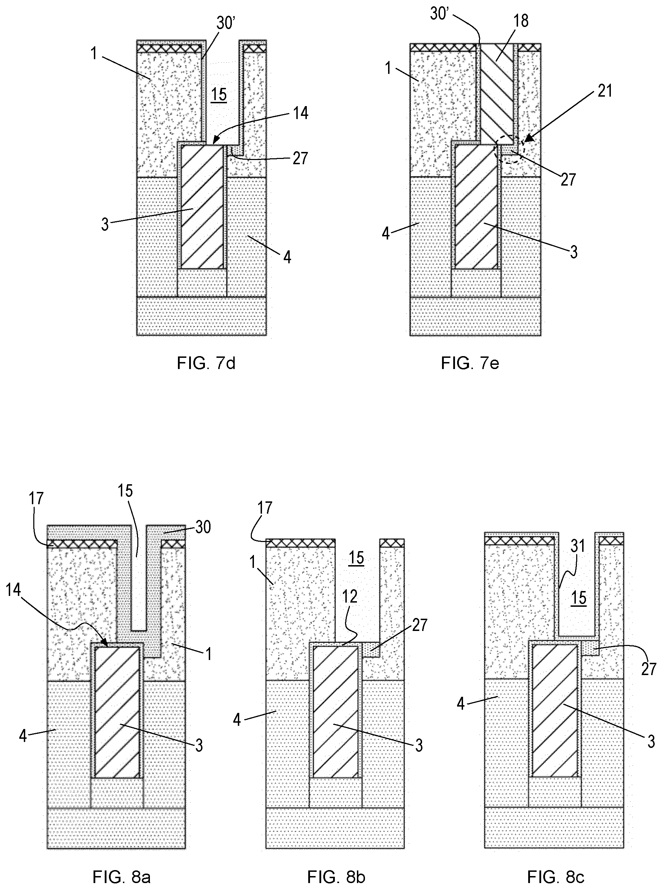

The thin remaining dielectric layer 30' is used as a liner for isolating the eventual TSV from the substrate 1, and is therefore subjected to an anisotropic etch process, for removing the liner 30' from the first part 26a of the bottom of the opening 15 and for removing the liner 12 from the end surface 14 of the buried rail 3 in the part of the opening overlapping said end surface 14, to thereby expose said end surface 14. When these layers have been removed, there still remains dielectric material in the cavity 27, as illustrated in Figure 7d. Therefore, when the via opening 15 is filled with metal, the final TSV 18 is effectively isolated from the substrate 1 in area 21 by the dielectric-filled cavity 27 and by the liner 30', as illustrated in Figure 7e.

It may be difficult to control the isotropic etch process so that the correct liner thickness 30' remains on the sidewalls and on the first part 26a of the bottom of the via opening 15. According to another embodiment illustrated in Figures 8a to 8e, the isotropic etch continues until all the dielectric material of layer 30 is removed from the sidewalls and from the first part 26a of the bottom of the via opening 15, whilst remaining in the cavity 27. This is illustrated in Figures 8a and 8b. It is seen that the hardmask layer 17 remains, i.e. in this embodiment the isotropic etch is selective with respect to the hardmask material.

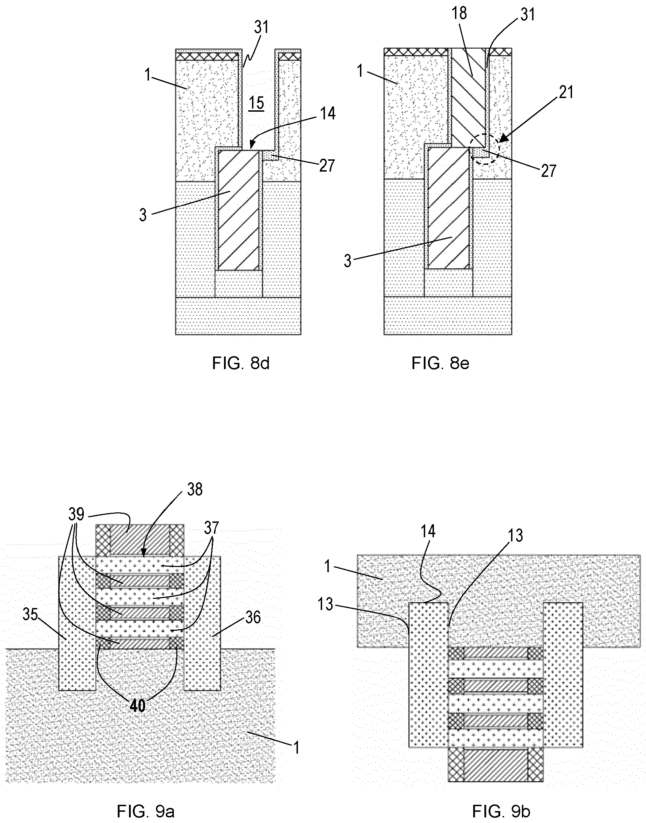

As shown in Figure 8c, a second dielectric layer 31 is then deposited, this time having the thickness of a standard liner. The second layer 31 may be formed of the same material as the first dielectric layer 30 or of a different material. This liner 31 and the liner 12 on the end surface 14 are then subjected to the usual anisotropic etch, exposing thereby the end surface 14, but stopping before removing the material of the first layer 30 from the cavity 27 (see Fig. 8d). As shown in Figure 8e, filling the via opening 15 then leads to a through substrate via 18 that is effectively isolated from the substrate 1 in the area 21, by the dielectric-filled cavity 27 and by the liner 31.

Figures 9a to 9h illustrate the application of the invention for contacting the source or drain of a nano-sheet transistor. This device is known as such, and comprises the following parts : two heavily doped regions, obtained by epitaxial growth, which serve as the source 35 and drain 36 of the transistor. The channel is formed by multiple thin semiconductor sheets 37, separated by a gate dielectric 38 and a metal gate 39 wrapped around the sheets. Dielectric spacers 40 further separate the gate from the source and drain. This type of device and methods for producing it are known as such. The source and drain are doped by opposite type dopants as the substrate 1 and are therefore not isolated from the substrate by a dielectric liner. However, when contacting the source or drain from the back side by a through substrate via (TSV), the TSV again needs to be isolated from the surrounding substrate material.

The substrate 1 is again attached face down to a carrier and thinned from the back side, as illustrated in Figure 9b (only the device and the portion of thinned substrate 1 onto which it was processed is shown). The source 35 and drain 36 extend in the direction perpendicular to the drawing. Even though the length of the source and drain is shorter than the length of a buried rail, they can nevertheless be characterized, like the buried rail, as electrically conductive structures defined by two sidewalls 13 and an end surface 14 buried in the substrate 1. The aim is now to contact the source or drain by a TSV produced through the thinned substrate 1 from the back side.

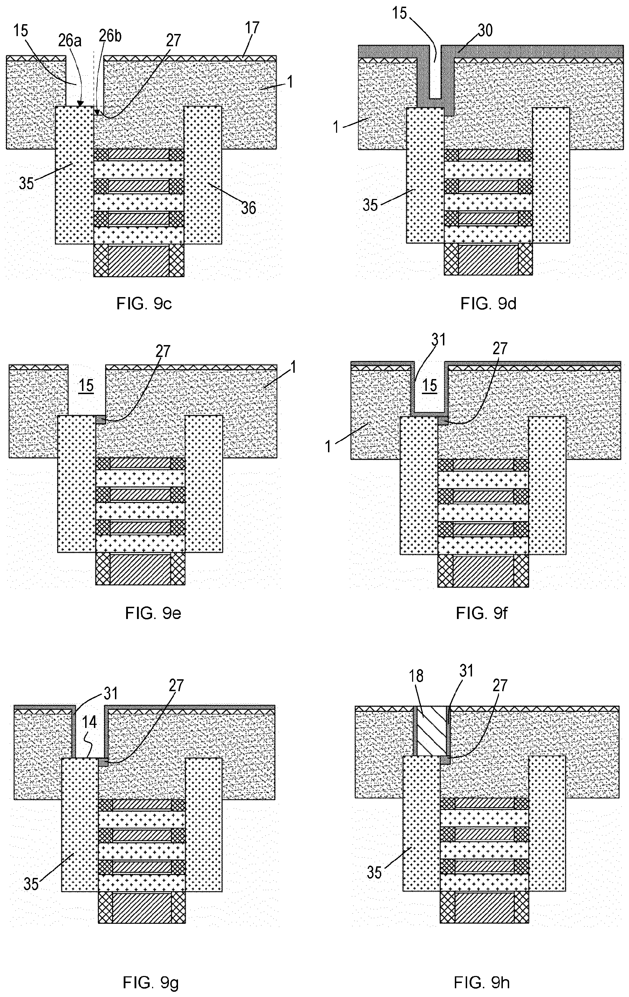

As shown in Figure 9c, a patterned hardmask 17 is formed and a via opening 15 is produced by lithography and etching. In the case shown, the via opening is misaligned to the width of the source 35. The etch process for producing the opening continues for a given depth beyond the end surface 14 of the source 35, so that the bottom of the opening has a first part 26a and a second part 26b that is deeper than the first part, i.e. forming a cavity 27 adjacent to the end surface 14 of the source 35. With reference to Figure 9d, a thick first dielectric layer 30 is deposited, filling the cavity 27 and forming a thick layer on the bottom and sidewalls of the via opening 15, without completely filling said opening 15. As shown in Figure 9e, the thick layer is removed everywhere except in the cavity 27, by an isotropic etch process. Then (Figure 9f), a second dielectric layer is deposited, forming a liner 31 on the first part 26a of the bottom of the via opening 15, on top of the dielectric-filled cavity 27 and on the sidewalls of the via opening 15. By an anisotropic etch, the liner 31 is removed from the bottom of the via opening 15, without however removing the material of the first dielectric layer 30 from the cavity 27 (see Figure 9g). The end surface 14 of the source 35 is now exposed. As seen in Figure 9h, filling the via opening with a metal then results in a TSV 18 that contacts the source 35, while being isolated from the substrate 1 by the dielectric-filled cavity 27 and by the liner 31.

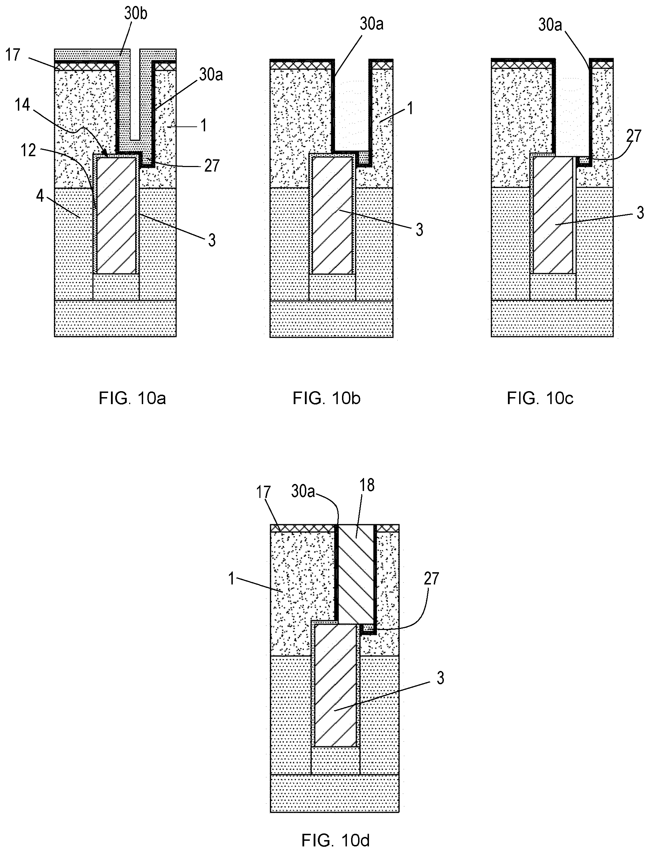

Figures 10a to 10c illustrate an embodiment wherein the thick first dielectric layer 30 is formed of a stack of a conformal thin first layer 30a and a thick second layer 30b. The first layer is conformal, in that it follows the topography defined by the cavity 27, i.e. the bottom and sidewalls of the cavity are lined with the first layer 30a. The second layer then fills the lined cavity and forms a thick layer on the sidewalls of the opening 15. The material of the second layer 30b is selectively removable by a selective etch process relative to the material of the first layer 30a. The first layer could for example be a layer of SiCO and the second a layer of SiO₂. As illustrated in Figure 10b, this enables removing the second layer 30b by such a selective etch process, leaving only the first layer 30a, which can then be treated like a liner, as in the previous embodiments. It is also possible to add an additional liner onto layer 30a to improve the isolation. The anisotropic etch of the liners 30a and 12 is illustrated in Figure 10c, followed by the filling of the opening to form the TSV 18, illustrated in Figure 10d. This embodiment is advantageous if the isotropic etch is not selective to the hardmask material of the hardmask layer 17 or exhibits insufficient etch selectivity to this material. The first layer 30a then protects the edges of the hardmask layer 17 around the opening 15.

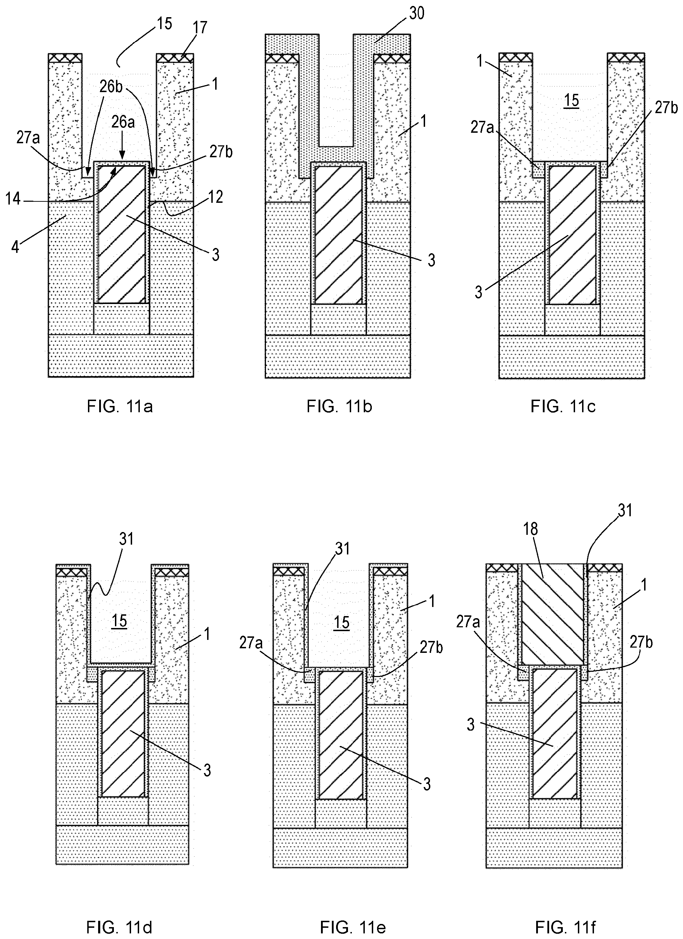

The method is applicable also when the TSV is wider than the buried rail to which it is to be connected. This is illustrated in Figures 11a to 11f. As seen in Figure 11a, the via opening 15 is slightly misaligned to the buried rail 3, thereby creating different-sized cavities 27a and 27b on both sides of the end surface 14 of the buried rail 3. The bottom of the two cavities combined now forms the second part 26b of the bottom of the opening 15, while the first part 26a is formed by the surface of the liner 12 covering the end surface 14 of the buried rail 3. The thick first dielectric layer 30 fills both cavities (Figure 11b), and after the isotropic etch, only the cavities remain filled with dielectric (Figure 11c). Then the second dielectric layer 31 is formed, forming a liner (Figure 11d), which is then removed from the bottom of the via opening 15, together with the liner 12 on the rail's end surface 14, but without removing the material of the first dielectric layer from the cavities (Figure 11e). As seen in Figure 11f, the metal-fill step then leads to the TSV 18, effectively isolated from the surrounding substrate by the dielectric-filled cavities 27a and 27b and by the liner 31.

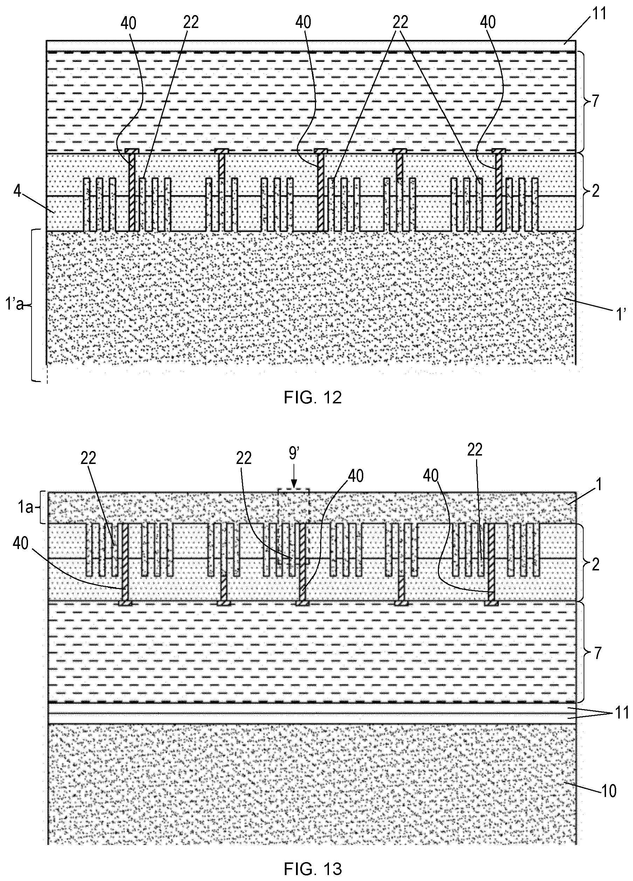

The invention is not limited to forming backside through-connections to structures which are buried in the bulk portion 1a of the thinned substrate at the front side thereof. The same method steps are applicable when the end surface of the structure to be contacted is close to active semiconductor structures at the front of the substrate. Reference is made to Figure 12, which shows another configuration comprising a FEOL portion 2 and BEOL portion 7 processed on a silicon substrate 1'. The FEOL portion now does not include buried power rails. Via connections 40 through the STI dielectric 4 are connected to the BEOL portion 7, and extend to the edge of the bulk portion 1'a of the substrate 1'. The via connections 40 are close to respective fins 22 onto which active devices such as transistors have been processed. These devices are not shown as such in the simplified drawing.

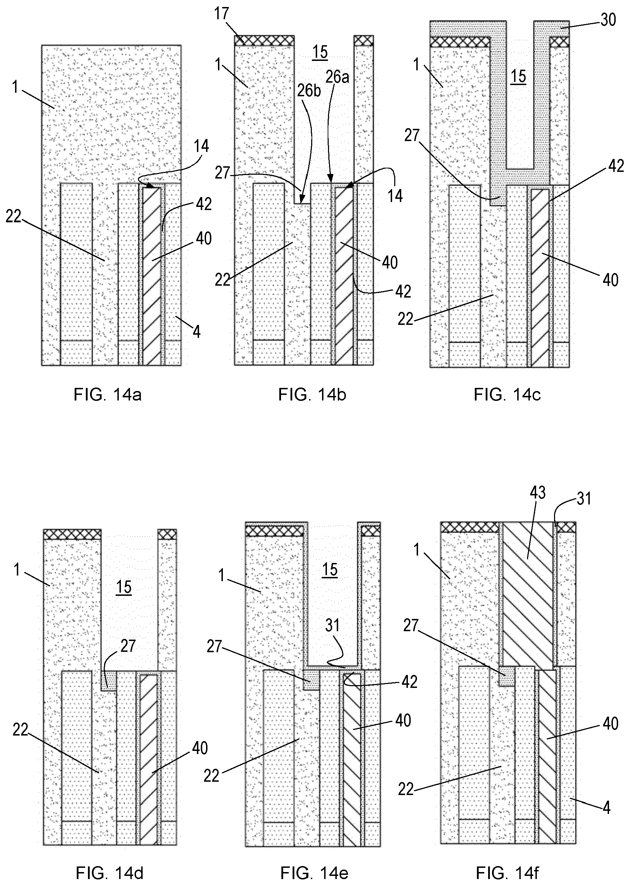

The aim is to thin the substrate 1' and to connect the via connections 40 to the back of the thinned substrate 1. Figure 13 shows the substrate after bonding face down to a carrier substrate 10 (or to another process wafer) through bonding layers 11, and after thinning the substrate 1' from the back side, thereby obtaining thinned substrate 1 comprising bulk portion 1a. The rectangle 9' indicated in Figure 13 is shown enlarged in Figure 14a. In this enlarged view, it is seen that the via connection 40 is isolated by a dielectric layer (liner) 42, which in particular separates the end surface 14 of the via connection 40 from the bulk portion 1a of the substrate 1. The liner 42 is optional within the broader scope of the invention, but it is preferred as it acts as an etch stop layer in the subsequent method step, as described hereafter.

With reference to Figure 14b, a hardmask layer 17 is formed on the thinned substrate and patterned, in order to produce an opening 15 through the back surface of the thinned substrate. In this embodiment, the opening 15 is an elongate trench 15, extending parallel to the fin 22 located closest to the via connection 40. The length of the trench 15 is considerably longer than the length of the via connection 40 in the longitudinal direction of the fin 22. The aim is to produce a power rail connecting the via connection 40, i.e. the 'through-connection' in this case is a power rail.

It is seen that the width of the opening 15 is misaligned to the width of the via connection 40. As in the previous embodiments, this misalignment is accidental and may not be the same across the substrate 1. In the particular case shown, the misalignment is such that the width of the bottom of the trench 15 overlaps the width of the fin 22, which can cause a short between the eventual through-connection and the fin 22, when the prior art methods are applied. The invention obstructs the formation of a short as described hereafter.

The etch process for creating the trench 15 is selective with respect to the STI dielectric 4 and with respect to the dielectric material of the liner 42 and therefore stops on the end surfaces of these materials, but the etch continues into the base of the fin 22, thereby creating a cavity 27. This is similar to the previous embodiment, except that the cavity is not directly adjacent the end surface 14 but separated therefrom by a portion of the STI dielectric. The cavity is however in the vicinity of the end surface 14. As in the previous embodiment, the bottom of the trench 15 comprises a first portion 26a that overlaps the end surface 14 of the via connection 40, and a second portion 26b defined by the bottom of the cavity 27.

After this, the same steps as described in relation to the previous embodiments are performed. The thick dielectric layer 30 is formed on the bottom and sidewalls of the trench 15, filling the cavity 27 (Fig. 14c). The material of layer 30 is removed by isotropic etching, leaving said material only in the cavity (Fig. 14d). A dielectric liner 31 is deposited conformally (Fig. 14e), and subsequently this liner and the liner 42 are removed from the bottom of the trench by an anisotropic etch process (not shown as a separate drawing). Finally, the trench is filled with metal and the upper surface is planarized (Fig. 14f), resulting in a power rail 43 realized from the back of the thinned substrate, that contacts the via connection 40 while being isolated from the fin 22 by the dielectric-filled cavity 27. By analogy with the embodiment shown in Figures 7a to 7e, it is also possible to thin the dielectric layer 30 on the sidewalls and bottom of the trench 15, and use the thinned layer 30 as the dielectric liner for isolating the eventual power rail 43 from the thinned substrate 1.

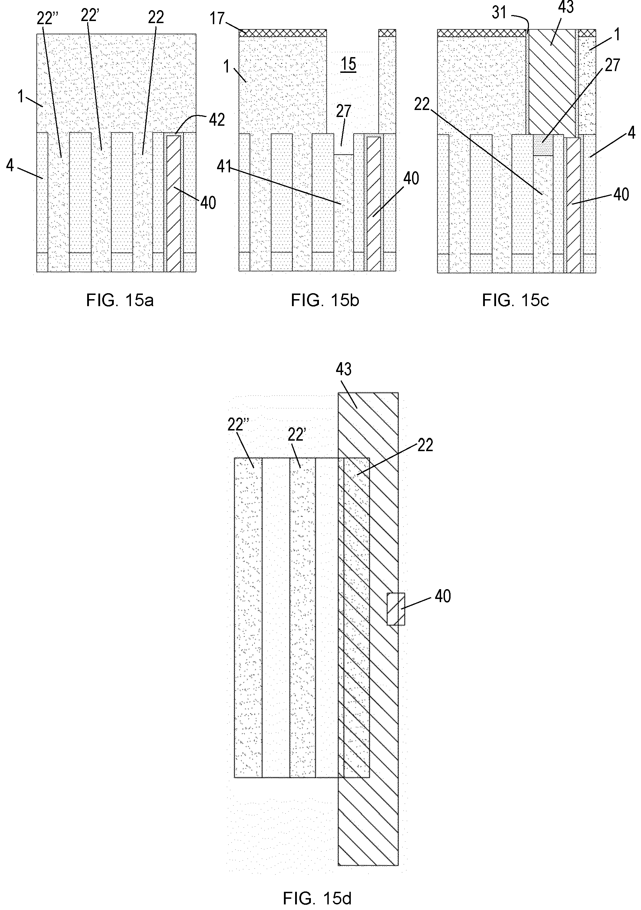

Figures 15a to 15c illustrate a case wherein the width of the trench overlaps the full width of the nearest fin 22. The image now also shows the two further fins 22' and 22" at equidistant spacings next to fin 22. The method steps are the same as in the previous case, starting with the formation of the trench 15 (Fig. 15b) and resulting in the image shown in Figure 15c. It is seen that the cavity 27 now fully covers the base of the fin 22. Figure 15d is a transparent and simplified top view (not including the dielectric liners), illustrating the position and in plane-dimensions of the via connection 40 and of the power rail 43, relative to the fins 22,22' and 22".

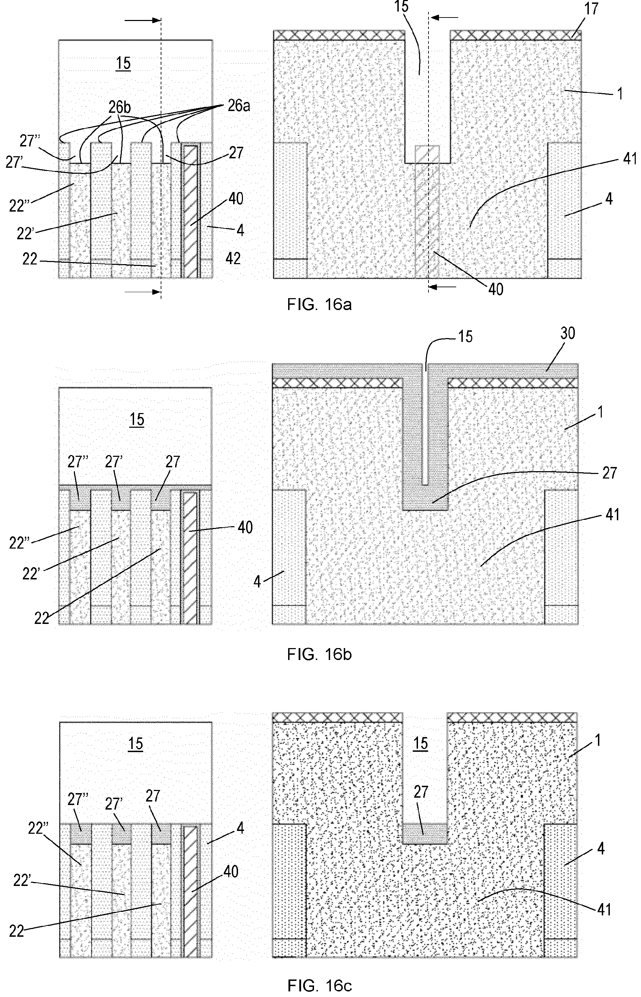

The method is furthermore applicable for contacting the via connection 40 by a power rail oriented transversally to the longitudinal direction of the fins 22. This is illustrated in Figures 16a to 16g. A cross-section through the first fin 22 is now also illustrated. Figure 16a illustrates the formation of the trench 15 oriented perpendicularly to the fins 22,22' and 22". The left-hand side image shows only part of the trench 115. The width and depth of the trench 15 is visible in the cross-section through the first fin 22 (right-hand side image), which also illustrates the position of the via connection 40 relative to the trench 15. It is seen that the trench 15 is perfectly aligned to the via connection 40. A degree of misalignment is possible, but the method is now also applicable in the illustrated perfectly aligned case, given the orientation of the trench, for obstructing the formation of shorts between the eventual rail and all the fins 22-22".

Etching of the trench 15 again continues beyond the end surfaces of the STI 4 and liner 42, which creates three cavities 27,27',27" which fully cover the base of the respective fins 22,22',22". The combined bottoms of the cavities define the second portion 26b of the bottom of the trench 15, while the combined higher-level portions define the first part 26a.

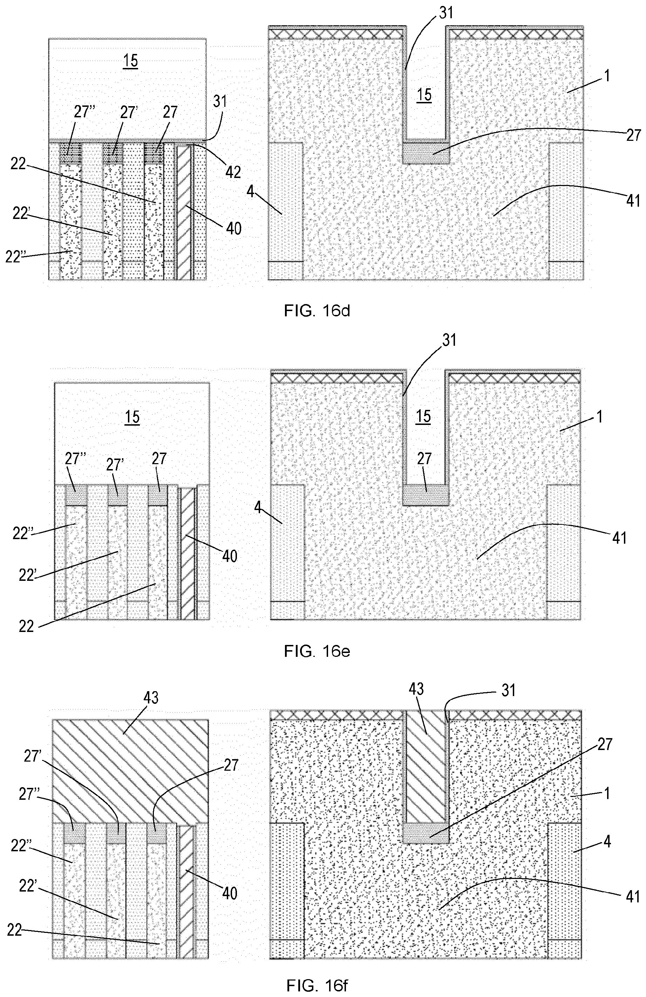

As seen in Figure 16b, the thick dielectric layer 30 is deposited, filling the cavities and extending conformally on the bottom and sidewalls of the trench 15. Isotropic etching of layer 30 results in the image shown in Figure 16c : the material of layer 30 remains only in the cavities 27-27". With reference to Figure 16d, a dielectric liner 31 is deposited, and thereafter removed from the bottom of the trench 15 by an anisotropic etch, removing also the liner 42 from the end surface of the via connection 40 thereby exposing said end surface, as illustrated in Figure 16e. Then a metal is deposited and planarized, resulting in the transverse rail 43 connected to the via connection 40, and isolated from the fins 22-22" by respective dielectric-filled cavities 27-27", as illustrated in Figure 16f.

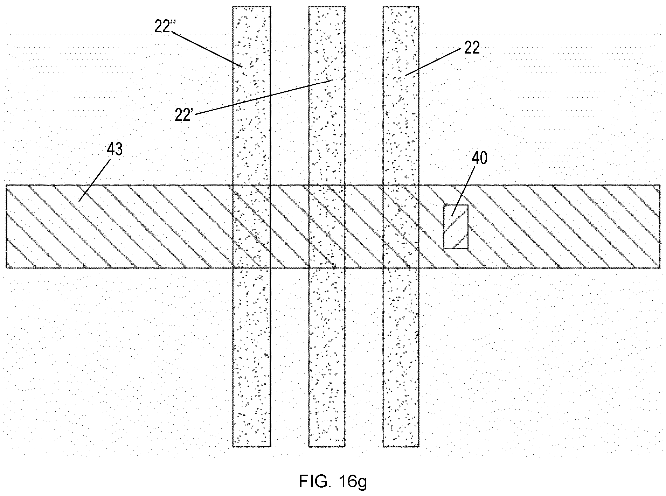

Figure 16g again shows a simplified transparent top view, illustrating the positions and in-plane dimensions of the rail 43 and the via connection 40, relative to the fins 22-22".

The invention is applicable for connecting various types of conductive structures at the front of the thinned substrate 1 by various types of through-connections produced from the back of the thinned substrate. For example, applying the same steps as described above, connections can be made between a via connection 40 at the front side and a TSV 18 through the substrate. The via connection 40 could also reach deeper into the bulk portion 1a of the substrate. In that case, one or more cavities 27 may be formed in said bulk portion, analogous to the embodiments shown in Figures 7 to 11.

A potential advantage of the invention, especially in the case of large through-connections through the thinned substrate, is the fact that the dimensions of the dielectric-filled cavity or cavities 27 and the material for filling the cavity or cavities can be configured to decrease stress in the substrate 1 generated in the vicinity of the through-connection by frontside and backside conductors. This would allow to reduce the size of a keep-out zone, i.e. a region around for example a TSV where the stress level is too high for producing semiconductor devices in said zone.

The method of the invention is applied simultaneously to a large number of conductive structures such as buried rails 3, source/drain areas 35 or via connections 40 distributed over a large substrate such as a process wafer. The degree of misalignment may be different across the substrate, so the isolation through dielectric-filled cavities 27 may not be needed in every opening 15 produced across the substrate. When the opening 15 is narrower than the structure and perfectly aligned to a buried rail 3 for example (as in Figures 4a to 4f), the method steps are performed as described above, but in that case no cavity 27 is formed adjacent the end surface 14 of the buried rail. The thick first dielectric layer 30 is deposited and subsequently this layer is thinned or completely removed by the isotropic etch. The invention thereby enables isolating all through-connections (TSVs, conductive lines or backside rails) perfectly from the substrate material, regardless of the width of the connections or of the degree of misalignment to the contacted structure.

A component produced by embodiments of the method of the invention can be recognized by the presence of a semiconductor substrate 1 and one or more dielectric-filled cavities 27, 27a, 27b, 27',27", at least one of which lies in the vicinity of the end surface 14 of a conductive structure such as a buried rail 3 or via connection 40 at the front side of the substrate . The end surface 14 of the conductive structure is contacted by a through-connection, for example a TSV 18 or a power rail 43, through the substrate 1 of the component. The through-connection is isolated from the substrate material by a liner 31 and by the one or more dielectric-filled cavities.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A method for producing an electrical connection (18,43) through a thinned semiconductor substrate (1), the substrate comprising a bulk portion (1a) having a front side and a back side, wherein multiple semiconductor devices at least partly formed of semiconductor material of the substrate are located on said front side, and wherein:
- said devices are part of a front end of line portion (2), said front end of line portion further comprising conductive structures (3,35,36,40) which are part of or connected to one or more of said semiconductor devices, one of said conductive structures having an end surface (14) that is to be contacted by the electrical connection (18,43),
- the method includes producing the front end of line portion (2) on the front side of an initial substrate (1') and thinning the initial substrate from the back side, to thereby obtain the thinned substrate (1),
wherein the method thereafter comprises the consecutively applied steps of :
- producing an opening (15) through the back side of the thinned substrate, by an etch process that is selective with respect to said end surface (14) of the conductive structure or with respect to a dielectric layer (12,42) isolating the conductive structure from the material of the substrate, wherein the bottom of said opening (15) overlaps :
∘ at least partially the end surface (14) of the conductive structure,
∘ one or more portions of semiconductor material of the substrate (1), and wherein the etch process continues beyond said end surface into said one or more semiconductor portions, so that at least one cavity (27) is formed, and so that the bottom of the opening (15) comprises:
∘ a first portion (26a) at least partially overlapping the end surface (14) of the conductive structure (3,35,36,40) and
∘ a second portion (26b) defined by the bottom of the cavity (27) or cavities, wherein material of the substrate is exposed in said second portion (26b) of the bottom of the opening (15),
- depositing a first dielectric layer (30) on the bottom and on the sidewalls of the opening (15), the thickness of said layer being such that the at least one cavity (27) is completely filled with the material of the first dielectric layer (30),
- partially removing the first dielectric layer (30) by an isotropic etch process configured to thin or completely remove the first dielectric layer on the sidewalls of the opening (15), and wherein the material of the first dielectric layer (30) is thinned or removed from the first part (26a) of the bottom of the opening (15) but maintained in the at least one cavity (27), to thereby create one or more dielectric-filled cavities (27),
- either using the thinned first dielectric layer (30') as a dielectric liner covering the sidewalls of the opening (15) and the first part (26a) of the bottom of the opening, or if the first dielectric layer (30) is fully removed from said sidewalls and first part (26a) of the bottom of the opening (15), depositing a second dielectric layer (31) to serve as said dielectric liner,
- by an anisotropic etch, exposing the end surface (14) of the conductive structure, whilst maintaining the dielectric liner (30',31) on the sidewalls of the opening (15) and whilst maintaining the material of the first dielectric layer (30) in the at least one cavity (27),
- filling the opening (15) with an electrically conductive material, to thereby form the electrical connection (18,43) through the thinned substrate (1), so that the connection (18,43) is isolated from the material of the substrate by the dielectric liner (30',31) and by the dielectric-filled cavity or cavities (27).

2. The method according to claim 1, wherein the end surface (14) of the conductive structure (3,35,36) is buried in the bulk portion (1a) of the substrate at the front side thereof, and wherein the opening (15) is misaligned and/or wider with respect to the width of the conductive structure in a given direction, so that the at least one cavity (27) is formed in the bulk portion (1a) of the substrate (1).

3. The method according to claim 2, wherein the conductive structure is a buried power rail (3) or wherein the conductive structure is a source or drain (35,36) of a transistor.

4. The method according to claim 1, wherein the end surface (14) of the conductive structure (40) is in close proximity to a semiconductor portion (22) of a semiconductor device located on the front side of the bulk portion (1a) of the substrate (1), and wherein the at least one cavity (27) is formed in said semiconductor portion (22) of said device.

5. The method according to claim 4, wherein the opening (15) is wider and/or misaligned with respect to the width of the conductive structure (40), as measured in a given direction.

6. The method according to claim 5, wherein the semiconductor portion (22) of the device is a fin-shaped portion (22) extending in a longitudinal direction and wherein said given direction is perpendicular to the longitudinal direction of the fin-shaped portion.

7. The method according to claim 5, wherein the semiconductor portion of the device is a fin-shaped portion (22) extending in a longitudinal direction and wherein the opening (15) is an elongate opening oriented transversely with respect to said longitudinal direction and wherein the length of the opening (15) fully overlaps the width of the fin-shaped portion (22).

8. The method according to any one of claims 4 to 7, wherein the conductive structure is a via connection (40).

9. The method according to any one of claims 1 to 6, wherein the electrical connection through the substrate is a through substrate via (18), a conductive line or a power rail (43).

10. The method according to any one of the preceding claims, wherein the first dielectric layer (30) is a uniform layer formed of a single dielectric material.

11. The method according to any one of claims 1 to 9, wherein the first dielectric layer (30) is a stack of a first and second dielectric layer (30a,30b), wherein the second layer (30b) is removable selectively with respect to the first layer (30a), by said isotropic etch process.

12. A semiconductor component comprising a semiconductor substrate (1) comprising a bulk portion (1a) having a front side and a back side, wherein the substrate (1) comprises a front end of line portion (2) on the front side of the bulk portion (1a), the front end of line portion comprising electrically conductive structures (3,35,36,40) which are part of or connected to semiconductor devices within said front end of line portion (2),
wherein the component comprises at least one electrical connection (18,43) passing through the substrate from the back side of the substrate (1) and contacting an end surface (14) of one of said conductive structures (3,35,36,40)
**characterised in that** the one electrical connection is isolated from the material of the substrate (1) by a dielectric liner (30',31), and by at least one dielectric-filled cavity (27) in the vicinity of the end surface (14) of the conductive structure (3,35,36,40).

13. The component according to claim 12, wherein the conductive structure is one of the following :
- a buried power rail (3),
- a source or drain (35,36) of a transistor,
- a via connection (40).

14. The component according to claim 12 or 13, wherein the electrical connection through the substrate is one of the following :
- a through substrate via (18),
- a conductive line,
- a power rail (43).

## Patentansprüche

1. Verfahren zum Herstellen einer elektrischen Verbindung (18, 43) durch ein ausgedünntes Halbleitersubstrat (1), wobei das Substrat einen Hauptabschnitt (1a) umfasst, der eine Vorder- und eine Rückseite aufweist, wobei mehrere Halbleitervorrichtungen, die zumindest teilweise aus Halbleitermaterial des Substrats gebildet sind, sich auf der Vorderseite befinden, und wobei:
- die Vorrichtungen Teil eines vorderen Zeilenendabschnitts (2), wobei dieser vordere Zeilenendabschnitt ferner leitfähige Strukturen (3, 35, 36, 40) umfasst, die Teil einer oder mehrerer der Halbleitervorrichtungen sind oder mit diesen verbunden sind, wobei eine der leitfähigen Strukturen eine Endfläche (14) aufweist, die von der elektrischen Verbindung (18, 43) kontaktiert werden soll,
- das Verfahren Herstellen des vorderen Zeilenendabschnitts (2) auf der Vorderseite eines Ausgangssubstrats (1') und Ausdünnen des Ausgangssubstrats von der Rückseite her beinhaltet, um dadurch das ausgedünnte Substrat (1) zu erhalten,
wobei das Verfahren anschließend die nacheinander angewandten Schritte umfasst:
- Herstellen einer Öffnung (15) durch die Rückseite des ausgedünnten Substrats durch einen Ätzprozess, der selektiv in Bezug auf die Endfläche (14) der leitfähigen Struktur oder in Bezug auf eine dielektrische Schicht (12, 42) ist, die die leitfähige Struktur vom Material des Substrats isoliert,
wobei der Boden der genannten Öffnung (15) Folgendes überlappt:
- zumindest teilweise die Endfläche (14) der leitfähigen Struktur,
- einen oder mehrere Abschnitte von Halbleitermaterial des Substrats (1),
und wobei der Ätzprozess über die Endfläche hinaus in den einen oder die mehreren Halbleiterabschnitte hinein fortgesetzt wird, sodass mindestens ein Hohlraum (27) gebildet wird und sodass der Boden der Öffnung (15) Folgendes umfasst:
- einen ersten Abschnitt (26a), der die Endfläche (14) der leitfähigen Struktur (3, 35, 36, 40) zumindest teilweise überlappt und
- einen zweiten Abschnitt (26b), der durch den Boden des Hohlraums (27) oder der Hohlräume gebildet wird, wobei Material des Substrats im zweiten Abschnitt (26b) des Bodens der Öffnung (15) freiliegt,
- Aufbringen einer ersten dielektrischen Schicht (30) auf den Boden und die Seitenwände der Öffnung (15), wobei die Dicke der Schicht so beschaffen ist, dass der mindestens eine Hohlraum (27) vollständig mit dem Material der ersten dielektrischen Schicht (30) gefüllt ist,
- teilweises Entfernen der ersten dielektrischen Schicht (30) durch einen isotropen Ätzprozess, der dazu konfiguriert ist, die erste dielektrische Schicht an den Seitenwänden der Öffnung (15) auszudünnen oder vollständig zu entfernen, und wobei das Material der ersten dielektrischen Schicht (30) im ersten Teil (26a) des Bodens der Öffnung (15) ausgedünnt oder entfernt wird, aber in dem mindestens einen Hohlraum (27) erhalten bleibt, um dadurch einen oder mehrere dielektrisch gefüllte Hohlräume (27) zu erzeugen,
- entweder Verwenden der ausgedünnten ersten dielektrischen Schicht (30') als eine dielektrische Auskleidung, die die Seitenwände der Öffnung (15) und den ersten Teil (26a) des Bodens der Öffnung bedeckt, oder, falls die erste dielektrische Schicht (30) vollständig von den Seitenwänden und dem ersten Teil (26a) des Bodens der Öffnung (15) entfernt ist, Abscheiden einer zweiten dielektrischen Schicht (31), die als die dielektrische Auskleidung dient,
- durch ein anisotropes Ätzen, Freilegen der Endfläche (14) der leitfähigen Struktur, während die dielektrische Auskleidung (30', 31) an den Seitenwänden der Öffnung (15) erhalten bleibt, und während das Material der ersten dielektrischen Schicht (30) in dem mindestens einen Hohlraum (27) erhalten bleibt,
- Füllen der Öffnung (15) mit einem elektrisch leitfähigen Material, um dadurch die elektrische Verbindung (18, 43) durch das ausgedünnte Substrat (1) zu bilden, sodass die Verbindung (18, 43) durch die dielektrische Auskleidung (30', 31) und durch den oder den dielektrisch gefüllten Hohlraum oder die Hohlräume (27) vom Material des Substrats isoliert ist.

2. Verfahren nach Anspruch 1, wobei die Endfläche (14) der leitfähigen Struktur (3, 35, 36) an dessen Vorderseite in den Hauptabschnitt (1a) des Substrats vergraben ist, und wobei die Öffnung (15) in Bezug auf die Breite der leitfähigen Struktur in einer vorgegebenen Richtung fehlausgerichtet und/oder breiter ist, sodass der mindestens eine Hohlraum (27) im Hauptabschnitt (1a) des Substrats (1) gebildet wird.

3. Verfahren nach Anspruch 2, wobei die leitfähige Struktur eine vergrabene Stromschiene (3) ist oder wobei die leitfähige Struktur eine Source oder Drain (35,36) eines Transistors ist.

4. Verfahren nach Anspruch 1, wobei die Endfläche (14) der leitfähigen Struktur (40) in unmittelbarer Nähe eines Halbleiterabschnitts (22) einer Halbleitervorrichtung ist, die sich auf der Vorderseite des Hauptabschnitts (1a) des Substrats (1) befindet, und wobei der mindestens eine Hohlraum (27) in dem Halbleiterabschnitt (22) der Vorrichtung gebildet ist.

5. Verfahren nach Anspruch 4, wobei die Öffnung (15) in Bezug auf die Breite der leitfähigen Struktur breiter und/oder fehlausgerichtet ist, wie in einer vorgegebenen Richtung gemessen.

6. Verfahren nach Anspruch 5, wobei der Halbleiterabschnitt (22) der Vorrichtung ein finnenförmiger Abschnitt (22) ist, der sich in einer Längsrichtung erstreckt, und wobei die vorgegebene Richtung senkrecht zu der Längsrichtung des finnenförmigen Abschnitts ist.

7. Verfahren nach Anspruch 5, wobei der Halbleiterabschnitt der Vorrichtung ein finnenförmiger Abschnitt (22) ist, der sich in einer Längsrichtung erstreckt, und wobei die Öffnung (15) eine längliche Öffnung ist, die in Bezug auf die Längsrichtung quer ausgerichtet ist, und wobei die Länge der Öffnung (15) die Breite des finnenförmigen Abschnitts (22) vollständig überlappt.

8. Verfahren nach einem der Ansprüche 4 bis 7, wobei die leitfähige Struktur eine Durchkontaktierungsverbindung (40) ist.

9. Verfahren nach einem der Ansprüche 1 bis 6, wobei die elektrische Verbindung durch das Substrat eine Substratdurchkontaktierung (18), eine leitfähige Leitung oder eine Stromschiene (43) ist.

10. Verfahren nach einem der vorstehenden Ansprüche, wobei die erste dielektrische Schicht (30) eine aus einem einzigen dielektrischen Material gebildete gleichmäßige Schicht ist.

11. Verfahren nach einem der Ansprüche 1 bis 9, wobei die erste dielektrische Schicht (30) ein Stapel einer ersten und zweiten dielektrischen Schicht (30a, 30b) ist, wobei die zweite Schicht (30b) selektiv in Bezug auf die erste Schicht (30a) durch den isotropen Ätzprozess entfernt werden kann.

12. Halbleiterbauelement, das ein Halbleitersubstrat (1) umfasst, das einen Hauptabschnitt (1a) umfasst, der eine Vorder- und eine Rückseite aufweist, wobei das Substrat (1) auf der Vorderseite des Hauptabschnitts (1a) einen vorderen Zeilenendabschnitt (2) aufweist, der vordere Zeilenendabschnitt elektrisch leitfähige Strukturen (3, 35, 36, 40) umfasst, die Teil von Halbleitervorrichtungen innerhalb des vorderen Zeilenendabschnitts (2) oder mit diesen verbunden sind,
wobei das Bauelement mindestens eine elektrische Verbindung (18, 43) umfasst, die von der Rückseite des Substrats (1) durch das Substrat hindurchführt und eine Endfläche (14) einer der leitfähigen Strukturen (3, 35, 36, 40) kontaktiert, **dadurch gekennzeichnet, dass** die eine elektrische Verbindung durch eine dielektrische Auskleidung (30', 31) und durch mindestens einen dielektrisch gefüllten Hohlraum (27) in der Nähe der Endfläche (14) der leitfähigen Struktur (3, 35, 36, 40) vom Material des Substrats (1) isoliert ist.

13. Bauelement nach Anspruch 12, wobei die leitfähige Struktur eine der folgenden ist:
- eine vergrabene Stromschiene (3),
- eine Source oder Drain (35, 36) eines Transistors,
- eine Durchkontaktierungsverbindung (40).

14. Bauelement nach Anspruch 12 oder 13, wobei die elektrische Verbindung durch das Substrat eine der folgenden ist:
- ein Substratdurchkontaktierung (18),
- eine leitfähige Leitung,
- eine Stromschiene (43).

## Revendications

1. Procédé de production d'une connexion électrique (18, 43) à travers un substrat semi-conducteur aminci (1), le substrat comprenant une portion massive (1a) présentant une face avant et une face arrière, dans lequel de multiples dispositifs semi-conducteurs au moins partiellement constitués d'un matériau semi-conducteur du substrat sont situés sur ladite face avant, et dans lequel :
- lesdits dispositifs font partie d'une face avant de portion ligne (2), ladite face avant de portion ligne comprenant en outre des structures conductrices (3, 35, 36, 40) qui font partie de ou sont connectées à un ou plusieurs desdits dispositifs semi-conducteurs, l'une desdites structures conductrices présentant une surface d'extrémité (14) qui doit entrer en contact avec la connexion électrique (18, 43),
- le procédé inclut la production de l'extrémité avant de portion ligne (2) sur la face avant d'un substrat initial (1') et l'amincissement du substrat initial depuis la face arrière, afin d'obtenir ainsi le substrat aminci (1),
dans lequel le procédé comprend ensuite les étapes appliquées de manière consécutive consistant à :
- produire une ouverture (15) à travers la face arrière du substrat aminci, par un processus de gravure qui est sélectif par rapport à ladite surface d'extrémité (14) de la structure conductrice ou par rapport à une couche diélectrique (12, 42) isolant la structure conductrice du matériau du substrat,
dans lequel le fond de ladite ouverture (15) chevauche :
○ au moins partiellement la surface d'extrémité (14) de la structure conductrice,
○ une ou plusieurs portions de matériau semi-conducteur du substrat (1),
et dans lequel le processus de gravure se poursuit au-delà de ladite surface d'extrémité dans lesdites une ou plusieurs portions semi-conductrices, de sorte qu'au moins une cavité (27) soit formée, et de telle façon que le fond de l'ouverture (15) comprenne :
○ une première portion (26a) chevauchant au moins partiellement la surface d'extrémité (14) de la structure conductrice (3, 35, 36, 40) et
○ une seconde portion (26b) définie par le fond de la cavité (27) ou des cavités, dans lequel le matériau du substrat est exposé dans ladite seconde portion (26b) du fond de l'ouverture (15),
- déposer une première couche diélectrique (30) sur le fond et sur les parois latérales de l'ouverture (15), l'épaisseur de ladite couche étant telle que la au moins une cavité (27) soit complètement remplie du matériau de la première couche diélectrique (30),
- éliminer partiellement la première couche diélectrique (30) par un processus de gravure isotrope configuré pour amincir ou éliminer complètement la première couche diélectrique sur les parois latérales de l'ouverture (15), et dans lequel le matériau de la première couche diélectrique (30) est aminci ou éliminé de la première partie (26a) du fond de l'ouverture (15) mais maintenu dans la au moins une cavité (27), afin de créer ainsi une ou plusieurs cavités remplies de diélectrique (27),
- utiliser la première couche diélectrique amincie (30') comme revêtement diélectrique recouvrant les parois latérales de l'ouverture (15) et la première partie (26a) du fond de l'ouverture, ou, si la première couche diélectrique (30) est entièrement éliminée desdites parois latérales et de ladite première partie (26a) du fond de l'ouverture (15), déposer une seconde couche diélectrique (31) pour servir dudit revêtement diélectrique,
- par gravure anisotrope, exposer la surface d'extrémité (14) de la structure conductrice, tout en maintenant le revêtement diélectrique (30', 31) sur les parois latérales de l'ouverture (15) et tout en maintenant le matériau de la première couche diélectrique (30) dans la au moins une cavité (27),
- remplir l'ouverture (15) d'un matériau électroconducteur, afin de former ainsi la connexion électrique (18, 43) à travers le substrat aminci (1), de telle façon que la connexion (18, 43) soit isolée du matériau du substrat par le revêtement diélectrique (30', 31) et par la cavité ou les cavités remplies de diélectrique (27).

2. Procédé selon la revendication 1, dans lequel la surface d'extrémité (14) de la structure conductrice (3, 35, 36) est enfouie dans la portion massive (1a) du substrat sur la face avant de celui-ci, et dans lequel l'ouverture (15) est décalée et/ou plus large par rapport à la largeur de la structure conductrice dans une direction donnée, de telle façon que la au moins une cavité (27) soit formée dans la portion massive (1a) du substrat (1).

3. Procédé selon la revendication 2, dans lequel la structure conductrice est un rail d'alimentation enfoui (3) ou dans lequel la structure conductrice est une source ou un drain (35, 36) d'un transistor.

4. Procédé selon la revendication 1, dans lequel la surface d'extrémité (14) de la structure conductrice (40) est proche d'une portion semi-conductrice (22) d'un dispositif semi-conducteur situé sur la face avant de la portion massive (1a) du substrat (1), et dans lequel la au moins une cavité (27) est formée dans ladite portion semi-conductrice (22) dudit dispositif.

5. Procédé selon la revendication 4, dans lequel l'ouverture (15) est plus large et/ou décalée par rapport à la largeur de la structure conductrice (40), telle que mesurée dans une direction donnée.

6. Procédé selon la revendication 5, dans lequel la portion semi-conductrice (22) du dispositif est une portion en forme d'ailette (22) s'étendant dans une direction longitudinale et dans lequel ladite direction donnée est perpendiculaire à la direction longitudinale de la portion en forme d'ailette.

7. Procédé selon la revendication 5, dans lequel la portion semi-conductrice du dispositif est une portion en forme d'ailette (22) s'étendant dans une direction longitudinale et dans lequel l'ouverture (15) est une ouverture allongée orientée transversalement par rapport à ladite direction longitudinale et dans lequel la longueur de l'ouverture (15) chevauche entièrement la largeur de la portion en forme d'ailette (22).

8. Procédé selon l'une quelconque des revendications 4 à 7, dans lequel la structure conductrice est une connexion par via (40).

9. Procédé selon l'une quelconque des revendications 1 à 6, dans lequel la connexion électrique à travers le substrat est un via à travers le substrat (18), une ligne conductrice ou un rail d'alimentation (43).

10. Procédé selon l'une quelconque des revendications précédentes, dans lequel la première couche diélectrique (30) est une couche uniforme constituée d'un seul matériau diélectrique.

11. Procédé selon l'une quelconque des revendications 1 à 9, dans lequel la première couche diélectrique (30) est un empilement d'une première et d'une seconde couche diélectrique (30a, 30b), dans lequel la seconde couche (30b) peut être retirée sélectivement par rapport à la première couche (30a), par ledit processus de gravure isotrope.

12. Composant semi-conducteur comprenant un substrat semi-conducteur (1) comprenant une portion massive (1a) présentant une face avant et une face arrière, dans lequel le substrat (1) comprend une extrémité avant de portion ligne (2) sur la face avant de la portion massive (1a), l'extrémité avant de portion ligne comprenant des structures électroconductrices (3, 35, 36, 40) qui font partie de ou sont connectées à des dispositifs semi-conducteurs dans ladite extrémité avant de portion ligne (2),
dans lequel le composant comprend au moins une connexion électrique (18, 43) traversant le substrat depuis la face arrière du substrat (1) et entrant en contact avec une surface d'extrémité (14) de l'une desdites structures conductrices (3, 35, 36, 40), **caractérisé en ce que** la connexion électrique est isolée du matériau du substrat (1) par un revêtement diélectrique (30', 31), et par au moins une cavité remplie de diélectrique (27) dans le voisinage de la surface d'extrémité (14) de la structure conductrice (3, 35, 36, 40).

13. Composant selon la revendication 12, dans lequel la structure conductrice est l'une des suivantes :
- un rail d'alimentation enfoui (3),
- une source ou un drain (35, 36) d'un transistor,
- une connexion par via (40).

14. Composant selon la revendication 12 ou 13, dans lequel la connexion électrique à travers le substrat est l'une des suivantes :
- un via à travers le substrat (18),
- une ligne conductrice,
- un rail d'alimentation (43).
